# EUROPEAN PATENT APPLICATION

(11) **EP 4 496 159 A1**
(43) Date of publication of application: **22.01.2025**
(21) Application number: 24175205.4
(22) Date of filing: 10.05.2024
(51) Int. Cl.: H02B 1/46, H05K 5/06, H02B 1/28, H01H 9/04

(54) **EXPLOSION-PROOF HOUSING AND ELECTRICAL DEVICE**

(30) Priority: 17.07.2023 CN 202321882148 U
(71) Applicant: Sungrow (Shanghai) Co., Ltd., Shanghai 201203 (CN)
(72) Inventor: WU, Zhengrong, Shanghai, 201203 (CN); ZHANG, Fanghui, Shanghai, 201203 (CN); ZHAO, Bo, Shanghai, 201203 (CN)
(74) Representative: Dehns Germany Partnerschaft mbB

(57) **Abstract**

The present disclosure discloses an explosion-proof housing and an electrical device. The explosion-proof housing includes a first housing body, a second housing body, a fastener, and a limit member. The first housing body has a first mounting hole. The second housing body covers the first housing body and has a second mounting hole. The fastener passes through the first mounting hole and the second mounting hole to connect the first housing body to the second housing body. The limit member is disposed between the first mounting hole and the fastener and has a first state and a second state. In the first state, the limit member is adapted to limit a limit head of the fastener outside the first mounting hole. In the second state, at least part of the limit member is disengaged from the limit head to allow the limit head to enter into the first mounting hole. As a result, seal performance of the explosion-proof housing in a use state can be ensured, and automatic pressure relief can be realized. Furthermore, rupture and fracture of a main structure such as the second housing body and the first housing body can be prevented. In this way, later maintenance cost can be reduced while improving use safety.

## Description

### FIELD

The present disclosure relates to the field of electrical device technologies, and more particularly, to an explosion-proof housing and an electrical device.

### BACKGROUND

In the related art, an electrical device that needs to meet a sealing condition has internal electrical parts, such as a capacitor, a switch, a relay, etc., prone to a dramatically intensified pressure, or even explosion when there is a short-circuit fault in the electrical device. A pressure from the explosion escalates as a power level, a voltage, and a current escalate. A generated immense pressure can cause a first housing body to explode or even to spatter. Therefore, it is essential to develop a first housing body structure that can relieve the pressure promptly and prevent the explosion.

### SUMMARY

The present disclosure aims to solve at least one of the technical problems in the related art. To this end, one object of the present disclosure is to provide an explosion-proof housing, which is capable of relieving a pressure promptly and has higher stability and reliability.

According to the present disclosure, there is further provided an electrical device using the above-mentioned explosion-proof housing.

According to embodiments in a first aspect of the present disclosure, there is provided an explosion-proof housing including a first housing body, a second housing body, a fastener, and a limit member. The first housing body has a first mounting hole. The second housing body covers the first housing body and has a second mounting hole. The fastener passes through the first mounting hole and the second mounting hole to connect the first housing body to the second housing body. The limit member is disposed between the first mounting hole and the fastener and has a first state and a second state. In the first state, the limit member is adapted to limit a limit head of the fastener outside the first mounting hole; and in the second state, at least part of the limit member is disengaged from the limit head to allow the limit head to enter into the first mounting hole. According to the embodiments of the present disclosure, by providing the limit member for the explosion-proof housing, the fastener can be switched between the first state and the second state. In the first state, seal performance of the explosion-proof housing in a use state can be ensured to improve use stability and use reliability of the explosion-proof housing. Furthermore, when the pressure inside the explosion-proof housing increases, the at least part of the limit member can be disengaged from the limit head (resulting in a structural change), to create a gap between the second housing body and the first housing body, which can not only realize automatic pressure relief, but also prevent rupture and fracture of a main structure such as the second housing body and the first housing body during the pressure relief. In this way, later maintenance cost can be reduced while improving use safety.

According to some embodiments of the present disclosure, the first mounting hole has a first end surface and a second end surface that are arranged in sequence in an assembly direction. In the first state, the limit head is located outside the first end surface; and in the second state, the limit head is located outside the second end surface.

According to some embodiments of the present disclosure, the limit member is constructed as a gasket disposed between the first mounting hole and the limit head. The gasket includes a gasket inner ring and a gasket outer ring. A weakened connection portion is disposed between the gasket inner ring and the gasket outer ring. The weakened connection portion is adapted to be broken under a pressure, disengaging the at least part of the limit member from the limit head in the second state.

According to some embodiments of the present disclosure, the limit member is constructed as a gasket disposed between the first mounting hole and the limit head and has a weakened connection portion. The weakened connection portion is adapted to be broken under a pressure, disengaging the limit member from the limit head in the second state.

According to some embodiments of the present disclosure, the limit member is disposed at an end portion of the first mounting hole and connected to the first housing body; and a weakened connection portion is disposed between the first housing body and the limit member. The weakened connection portion is adapted to be broken under a pressure, disengaging the limit member from the limit head in the second state.

According to some embodiments of the present disclosure, the limit member is disposed at the limit head; and a weakened connection portion is disposed between the limit head and the limit member. The weakened connection portion is adapted to be broken under a pressure, disengaging the limit member from the limit head in the second state.

In some embodiments, the weakened connection portion includes weakened slits. The weakened slits each have a thickness smaller than a thickness of the limit member to disengage the at least part of the limit member from the limit head.

Further, the weakened connection portion further includes a weakened groove. The weakened groove is constructed as a through groove to disengage the at least part of the limit member from the limit head.

Further, the weakened groove is disposed between the at least two weakened slits.

In some embodiments, the weakened slits are disposed about an axis of the first mounting hole.

Further, a plurality of weakened grooves is provided and arranged at equal intervals.

Further, the plurality of weakened grooves is constructed as annular-shaped grooves and arranged about an axis of the first mounting hole at equiangular intervals.

According to some embodiments of the present disclosure, the first end surface has an inner diameter smaller than an inner diameter of the gasket outer ring and greater than an outer diameter of the gasket inner ring.

In some embodiments, the second end surface has an inner diameter smaller than an inner diameter of the gasket inner ring and an outer diameter greater than or equal to an outer diameter of the gasket inner ring.

Further, the fastener has an end extending into the first mounting hole and the second mounting hole; and the limit head has an outer diameter smaller than an inner diameter of the gasket outer ring to remove the gasket outer ring from the fastener after the gasket outer ring is separated from the gasket inner ring.

According to embodiments in a second aspect of the present disclosure, there is provided an electrical device including the explosion-proof housing described in above embodiments.

Additional aspects and advantages of the embodiments of present disclosure will be provided at least in part in the following description, or will become apparent from the following description, or can be learned from the practice of the present disclosure.

### BRIEF DESCRIPTION OF THE DRAWINGS

These and other aspects and advantages of embodiments of the present disclosure will become apparent and more readily appreciated from the following descriptions made with reference to the accompanying drawings.
FIG. 1 is a schematic diagram from an angle of an explosion-proof housing in a use state according to an embodiment of the present disclosure.
FIG. 2 is a schematic diagram from another angle of an explosion-proof housing in a use state according to an embodiment of the present disclosure.
FIG. 3 is a partially enlarged schematic diagram of a circled A region in FIG. 2.
FIG. 4 is a schematic diagram from an angle of an explosion-proof housing in a pressure relief state according to a first embodiment of the present disclosure.
FIG. 5 is a schematic diagram from another angle of an explosion-proof housing in a pressure relief state according to a first embodiment of the present disclosure.
FIG. 6 is a partially enlarged schematic diagram of a circled region B in FIG. 5.
FIG. 7 is a schematic diagram of a first housing body according to a first embodiment of the present disclosure.
FIG. 8 is a partially section schematic diagram of a first housing body according to a first embodiment of the present disclosure.
FIG. 9 is a schematic diagram of a gasket according to a first embodiment of the present disclosure.
FIG. 10 is a schematic diagram from an angle of engagement between a gasket and a fastener according to a first embodiment of the present disclosure.
FIG. 11 is a schematic diagram from another angle of engagement between a gasket and a fastener according to a first embodiment of the present disclosure.
FIG. 12 is a schematic diagram of engagement between a first housing body and a fastener and a limit member according to a second embodiment of the present disclosure.
FIG. 13 is a schematic diagram of engagement between a fastener and a limit member according to a second embodiment of the present disclosure.
FIG. 14 is a partially enlarged schematic diagram of an explosion-proof housing according to a third embodiment of the present disclosure.
FIG. 15 is a partially enlarged schematic diagram of an explosion-proof housing according to a fourth embodiment of the present disclosure.
FIG. 16 is a schematic diagram of engagement between a fastener and a limit member according to a fourth embodiment of the present disclosure.

### Reference numerals:

explosion-proof housing 100,
first housing body 10, first mounting hole 11, first end surface 111, second end surface 112,
second housing body 20, second mounting hole 21,
fastener 30, limit head 31,
limit member 40, gasket inner ring 41, gasket outer ring 42, weakened slit 43, weakened groove 44, and
elastic washer 50.

### DETAILED DESCRIPTION

The embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain rather than limit the present disclosure.

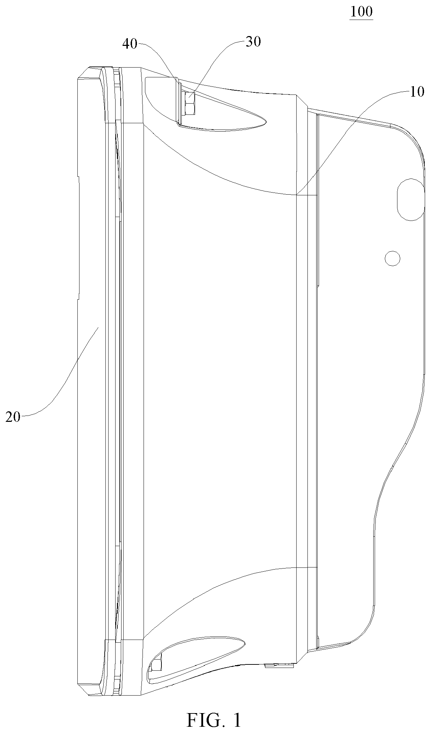

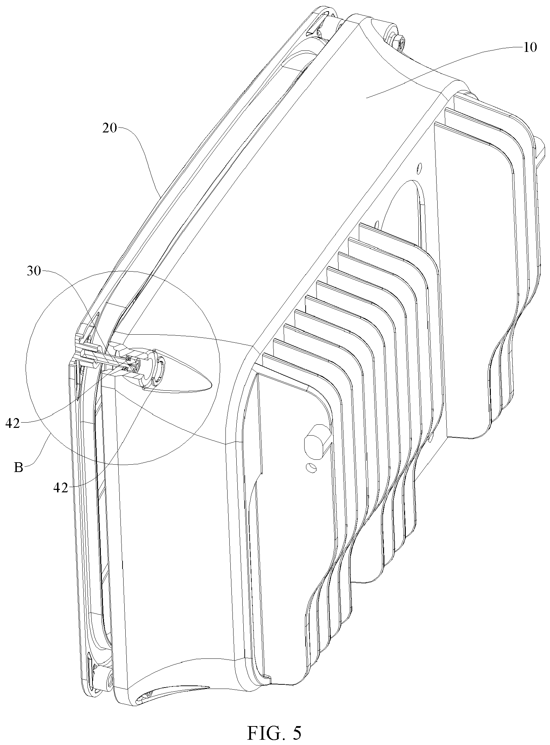

An explosion-proof housing 100 and an electrical device according to an embodiment of the present disclosure are described below with reference to FIGS. 1 to 16.

As illustrated in FIGS. 1 to 6 and FIGS. 12 to 16, an explosion-proof housing 100 according to embodiments in a first aspect of the present disclosure includes a first housing body 10, a second housing body 20, a fastener 30, and a gasket. The first housing body 10 has a first mounting hole 11. The second housing body 20 covers the first housing body 10 and has a second mounting hole 21. The fastener 30 passes through the first mounting hole 11 and second mounting holes 21 to connect the first housing body 10 to the second housing body 20. The limit member 40 is disposed between the first mounting hole 11 and the fastener 30 and has a first state and a second state. In the first state, the limit member 40 is adapted to limit a limit head 31 of the fastener 30 outside the first mounting holes 11. In the second state, at least part of the limit member 40 is disengaged from the limit head 31 to allow the limit head 31 to enter into the first mounting hole 11.

In an exemplary embodiment of the present disclosure, the first housing body 10 and the second housing body 20 define an accommodation space. Four corner regions of the first housing body 10 may have four first mounting holes 11 respectively, and correspondingly, four corner regions of the second housing body 20 may have four second mounting holes 21 respectively. At least part of the second mounting hole 21 is formed as a threaded hole. The fastener 30 is constructed as a threaded structural member such as a bolt, a screw, etc., such that the fastener 30 may pass through the first mounting hole 11 and in a thread fit with the second mounting hole 21 to realize a fixed connection between the second housing body 20 and the first housing body 10. The gasket may be disposed between an end surface of the first mounting hole 11 and the fastener 30 to realize a seal between the first housing body 10 and the second housing body 20.

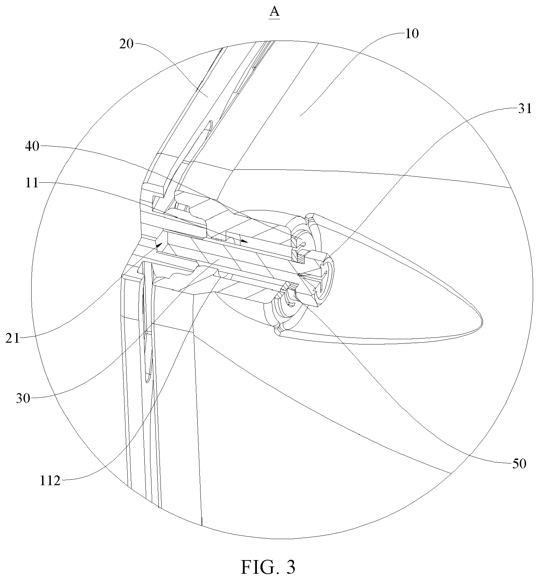

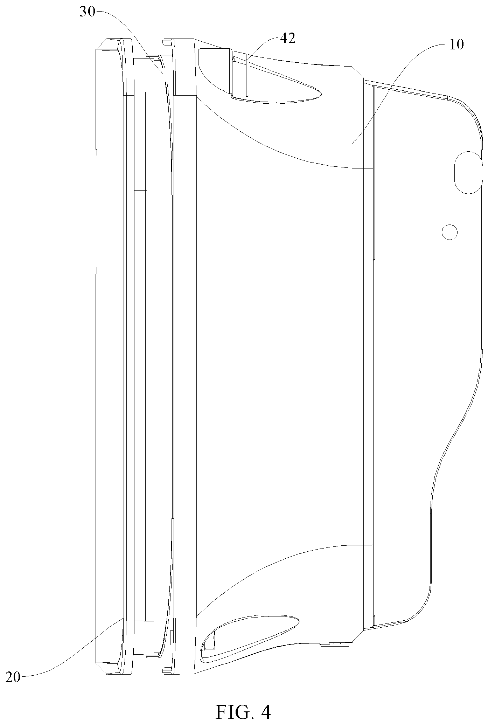

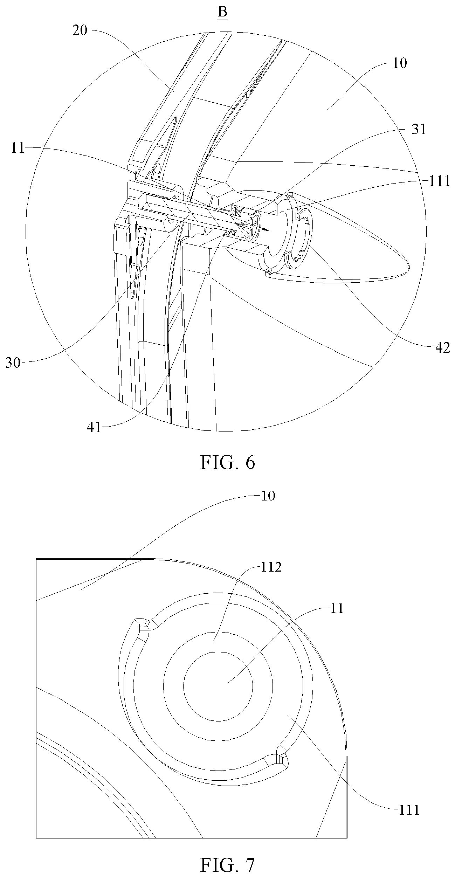

Further, as illustrated in FIGS. 1 and 3, the explosion-proof housing 100 has a use state. As illustrated in FIGS. 4 and 6, the explosion-proof housing 100 also has a pressure relief state. In a seal state, there is no gap in a sealed engagement between the second housing body 20 and the first housing body 10. In the pressure relief state, a gap is defined between the second housing body 20 and the first housing body 10. A pressure within the accommodation space can be released by the gap to improve safety and reliability of the explosion-proof housing 100.

Correspondingly, when the limit member 40 is in the first state, the explosion-proof housing 100 is in the use state. In this case, the limit head 31 is located outside the first mounting hole 11, and there is no gap in a sealed engagement between the first housing body 10 and the second housing body 20. When the limit member 40 is in the second state, the explosion-proof housing 100 is in the pressure relief state. In this case, the at least part of the limit member 40 is disengaged with the limit head 31. The limit head 31 is in a free state and may enter into the first mounting hole 11 to create a gap between the first housing body 10 and the second housing body 20 for the pressure relief.

It is to be noted that the limit member 40 may have a variety of structural shapes, and at least four feasible structures from a first embodiment to a fourth embodiment are illustrated exemplarily below. It should be understood that the first embodiment to the fourth embodiment are feasible embodiments of the present disclosure, and are not an exhaustive list.

In an exemplary embodiment of the present disclosure, in the second state, the at least part of the limit member 40 being disengaged from the limit head 31 may be that the limit member 40 is completely disengaged from the limit head 31 (referring to a second embodiment, a third embodiment, and the fourth embodiment); or it may be that a part of the limit member 40 is disengaged from the limit head 31, while another part of the limit member 40 is still engaged with the limit head 31 and may enter the first mounting hole 11 together with the limit head 31.

According to the embodiments of the present disclosure, by providing the limit member 40 for the explosion-proof housing 100, the fastener 30 can be switched between the first state and the second state. In the first state, seal performance of the explosion-proof housing 100 in the use state can be ensured to improve the use stability and the use reliability of the explosion-proof housing 100. Furthermore, when the pressure inside the explosion-proof housing 100 increases, the at least part of the limit member 40 can be disengaged from the limit head 31 (resulting in a structural change), to create the gap between the second housing body 20 and the first housing body 10, which can not only realize automatic pressure relief, but also prevent rupture and fracture of a main structure such as the second housing body 20 and the first housing body 10 during the pressure relief. In this way, later maintenance cost can be reduced while improving use safety.

As illustrated in FIGS. 3 and 6, an elastic washer 50 may also be disposed between the fastener 30 and the first mounting hole 11. A friction force as well as a bite force of the fastener 30 can be improved by the elastic washer 50 to improve stability and reliability of the fixation of the first housing body 10 and the second housing body 20 by the fastener 30.

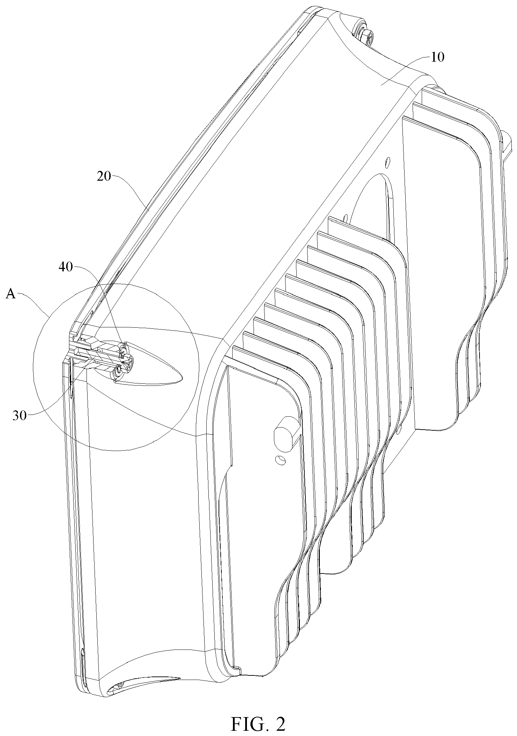

As illustrated in FIGS. 2, 3, 6, 12, and 15, the first mounting hole 11 has a first end surface 111 and a second end surface 112 that are arranged in sequence in an assembly direction. In the first state, the limit head 31 is located outside the first end surface 111. In the second state, the limit head 31 is located outside the second end surface 112.

In an exemplary embodiment of the present disclosure, the first mounting hole 11 or the second mounting hole 21 has a first end surface 111 and a second end surface 112 that are arranged in sequence in an assembly direction. When the limit head 31 is pushed to abut with the first end surface 111, the limit member 40 is correspondingly in the first state. When the limit member 40 is in the second state, the limit head 31 is pushed to abut with the second end surface 112 to realize the switching of the explosion-proof housing 100 between the use state and the pressure relief state, and to improve the use safety of the explosion-proof housing 100.

Hereinafter, the explosion-proof housing 100 of the present disclosure is illustrated exemplarily from the first embodiment to the fourth embodiment.

As illustrated in FIGS. 1 to 11, in the first embodiment, the limit member 40 is constructed as a gasket. The gasket is disposed between the first mounting hole 11 and the limit head 31. The gasket includes a gasket inner ring 41 and a gasket outer ring 42 that are arranged in sequence in a radial direction. A weakened connection portion is disposed between the gasket inner ring 41 and the gasket outer ring 42. The weakened connection portion is adapted to be broken under a pressure, disengaging the at least part of the limit member 40 from the limit head 31 in the second state. The gasket outer ring 42 is adapted to be separated from the gasket inner ring 41 under a pressure. The gasket outer ring 42 is adapted to be pushed to abut with the first end surface 111. The gasket inner ring 41 is adapted to be pushed to abut with the second end surface 112.

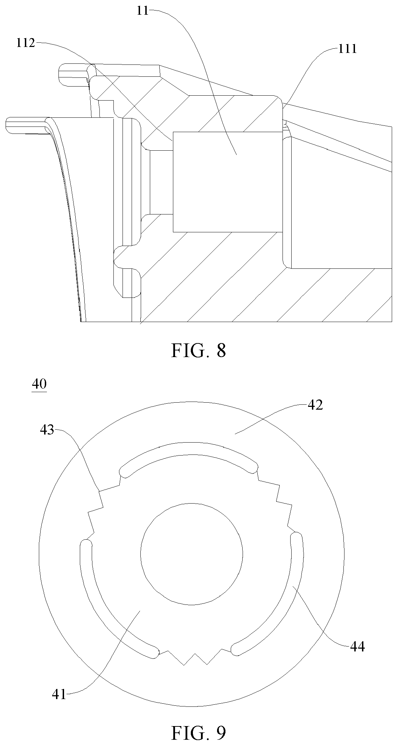

Exemplarily, in an embodiment where the fastener 30 passes through the first mounting hole 11 and is in a thread fit with the second mounting hole 21, the first mounting hole 11 has a first end surface 111 and a second end surface 112 as illustrated in FIGS. 7 and 8. The first end surface 111 and the second end surface 112 are arranged in sequence in an assembly direction and spaced apart from each other, and a gasket outer ring 42 of a corresponding gasket may abut with the first end surface 111 to be engaged with each other. In this case, the explosion-proof housing 100 is in the use state illustrated in FIGS. 1 to 3. When the explosion-proof housing 100 has an excessively high pressure, the pressure pushes the second housing body 20 to move away from the first housing body 10, an acting force acts on the fastener 30 and disengages the gasket outer ring 42 of the gasket from the gasket inner ring 41. Consequently, the pressure pushes the second housing body 20 to move away from the first housing body 10 to be in the pressure relief state illustrated in FIGS. 4 to 6, and the gasket inner ring 41 of the gasket may abut with the second end surface 112 to be engaged with each other.

In the first embodiment, the explosion-proof housing 100 according to the embodiments of the present disclosure, the first end surface 111 and the second end surface 112 are provided, and the gasket outer ring 42 and the gasket inner ring 41 abut with the first end surface 111 and the second end surface 112 respectively to be engaged with each other, the sealing performance of the explosion-proof housing 100 can be ensured under the use state to improve the use stability and the reliability of the explosion-proof housing 100. Furthermore, when the pressure inside the explosion-proof housing 100 increases, the gasket can absorb energy and structurally changes. In addition, the gasket inner ring 41 abuts with the second end surface 112 to be engaged with each other, to create the gap between the second housing body 20 and the first housing body 10, which can not only realize the automatic pressure relief, but also prevent the rupture and the fracture of the main structure such as the second housing body 20 and the first housing body 10 during the pressure relief. In this way, the later maintenance cost can be reduced while improving the use safety.

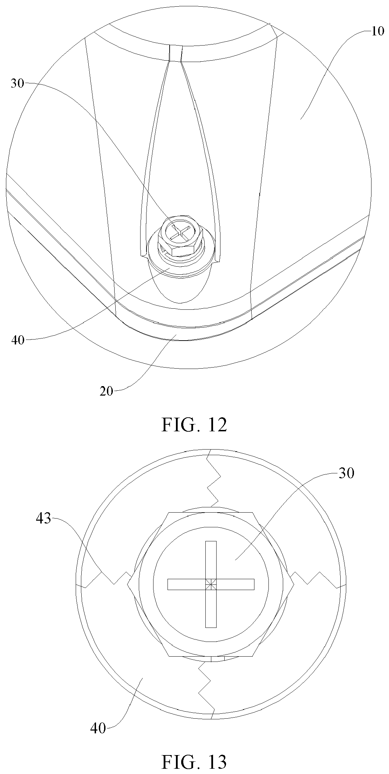

As illustrated in FIGS. 12 and 13, in the second embodiment, the limit member 40 is constructed as a gasket. The gasket is disposed between the first mounting hole 11 and the limit head 31 and has a weakened connection portion. The weakened connection portion is adapted to be broken under a pressure, disengaging the limit member 40 from the limit head 31 in the second state.

That is, the second embodiment can achieve the same technical effect as the first embodiment, with a difference that in the second embodiment, the gasket structure of the limit member 40 is different from the gasket structure in the first embodiment in that a limitation is realized by the limit member 40 only in the first state, while in the second state, the limit member 40 fails and disengages from the fastener 30.

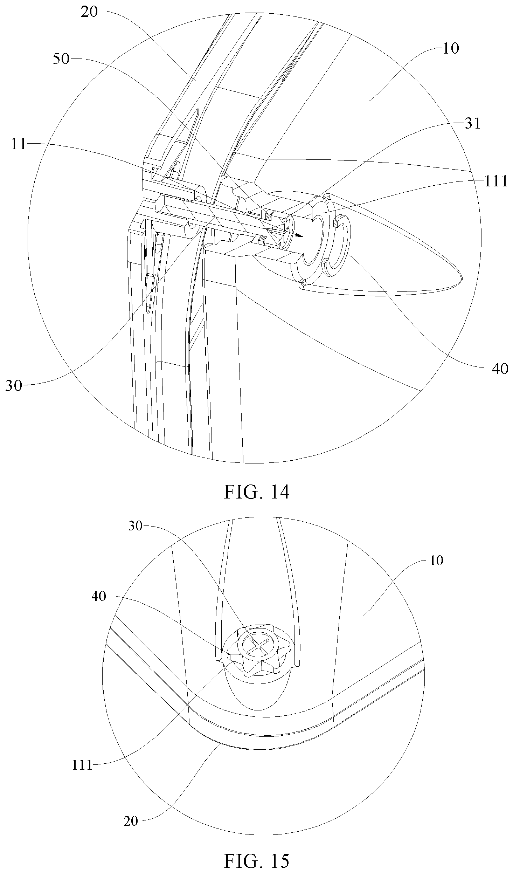

As illustrated in FIG. 14, in the third embodiment, the limit member 40 is disposed at an end portion of the first mounting hole 11 and connected to the first housing body 10, and a weakened connection portion is disposed between the first housing body 10 and the limit member 40. The weakened connection portion is adapted to be broken under a pressure, disengaging the limit member 40 from the limit head 31 in the second state.

In an exemplary embodiment of the present disclosure, the third embodiment can also achieve the same technical effect as the first embodiment, with a difference from the first embodiment and the second embodiment that the limit member 40 is disposed at the first housing body 10 instead of being separately disposed, and the limit member 40 is completely disengaged from the limit head 31 in the second state.

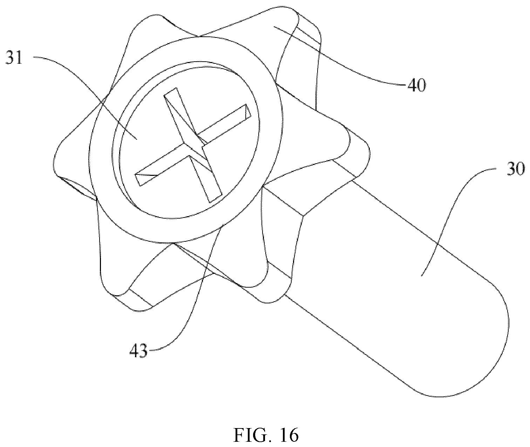

As illustrated in FIGS. 15 and 16, in the fourth embodiment, the limit member 40 is disposed at the limit head 31, and a weakened connection portion is disposed between the limit head 31 and the limit member 40. The weakened connection portion is adapted to be broken under a pressure, disengaging the limit member 40 from the limit head 31 in the second state.

The fourth embodiment can also achieve the same technical effect as the first embodiment, with a difference from the first embodiment, the second embodiment, and the third embodiment that the limit member 40 is disposed at the limit head 31 of the fastener 30 instead of being separately disposed, and the limit member 40 is completely disengaged from the limit head 31 in the second state.

In summary, in each of the first embodiment, the second embodiment, the third embodiment and the fourth embodiment, the limit member 40 includes the weakened connection portion, and the limit member 40 itself is constructed as a crushable split structure and is connected by the weakened connection portion (the first embodiment); or the limit member 40 realizes its own crushable disintegration through the weakened connection portion (the second embodiment); or the limit member 40 is connected to surrounding components through the weakened connection portion (for example, the limit member 40 is connected to the first housing body 10 in the third embodiment and connected to the fastener 30 in the fourth embodiment), the limit member 40 can be switched between the first state and the second state to realize the switching of the explosion-proof housing 100 between the use state and the pressure relief state. In this way, the maintenance cost is reduced, and the use safety is improved.

In some embodiments, as illustrated in FIGS. 9, 13, 14, and 16, the weakened connection portion includes weakened slits 43. The weakened slits 43 each has a thickness smaller than a thickness of the limit member 40 to disengage the at least part of the limit member 40 from the limit head 31.

In an exemplary embodiment of the present disclosure, as illustrated in FIG. 9, in the first embodiment, a weakened connection portion is disposed between the gasket inner ring 41 and the gasket outer ring 42. The weakened connection portion is adapted to be broken under a pressure, disengaging the gasket inner ring 41 from the gasket outer ring 42.

The gasket is in a circular shape as a whole and has a through hole at a middle part of the gasket for the fastener 30 to pass through. The gasket includes a first annular-shaped portion and a second annular-shaped portion that are arranged in sequence in a radial direction of itself. The first annular-shaped portion is defined as the gasket inner ring 41 and the second annular-shaped portion is defined as the gasket outer ring 42. A weakened connection portion may be disposed between the gasket inner ring 41 and the gasket outer ring 42. The weakened connection portion fractures, collapses, or deforms when the gasket is subjected to a pressure that exceeds a pressure threshold, which can disengage the gasket inner ring 41 from the gasket outer ring 42. The gasket outer ring 42 having a larger diameter may be disengaged from the fastener 30 or at least partially disengaged from the fastener 30 after the gasket outer ring 42 having the larger diameter is disengaged from the gasket inner ring 41. Correspondingly, the fastener 30 and the gasket inner ring 41 can move to the second end surface 112 to be engaged with the second end surface 112 under the pressure in the explosion-proof housing 100, and therefore only the gasket can be broken during the pressure relief of the explosion-proof housing 100, reducing the cost of the pressure relief of the explosion-proof housing 100, avoiding the rupture of the first housing body 10 and the second housing body 20, and reducing the cost of the later maintenance.

As illustrated in FIG. 13, in the second embodiment, the weakened silt 43 extends in a radial direction of the gasket, which reduces structural strength of the gasket itself and allows the gasket to be broken into a one-piece or multiple-piece structure to achieve the switching between the first state and the second state. As illustrated in FIG. 14, in the third embodiment, the weakened silts 43 may be disposed around a connection region between the limit member 40 and the first housing body 10 to reduce connection strength between the first housing body 10 and the limit member 40 to realize the switching between the first state and the second state. As illustrated in FIG. 16, in the fourth embodiment, the weakened silts 43 may be disposed around a connection region between the limit member 40 and the fastener 30 to reduce connection strength between the fastener 30 and the limit member 40 to realize the switching between the first state and the second state.

As such, strength of the limit member 40 can be reduced by the weakened silts 43, allowing the limit member 40 to promptly rupture or collapse when the pressure in the explosion-proof housing 100 reaches a safety threshold, to realize the promptly pressure relief and the explosion proofing, and to improve the use safety of the explosion-proof housing 100.

In an exemplary embodiment of the present disclosure, a contour of the weakened slits 43 within a projection range in a thickness direction of the gasket is formed into a sawtooth shape, an arc shape, etc., which may be formed into a dent to realize a weakened connection between the gasket outer ring 42 and the gasket inner ring 41 and can ensure that the gasket inner ring 41 and the gasket outer ring 42 are not easily deformed or broken under the use state, improving the stability and the reliability of the explosion-proof housing 100 under the use state.

Further, the weakened connection portion further includes a weakened groove 44. The weakening groove 44 is constructed as a through groove to disengage the at least part of the limit member 40 from the limit head 31. As such, the structural strength of the limit member 40 can be further reduced by the weakening groove 44, allowing the limit member 40 to be switched to the second state promptly to improve the stability and the reliability of the pressure relief of the explosion-proof housing 100.

As illustrated in FIG. 9, in an exemplary embodiment of the present disclosure, a weakened groove 44 is disposed between at least two weakened silts 43. For example, in the first embodiment, the structural strength of the limit member 40 can be effectively reduced by cooperation of the weakened silts 43 and the weakened groove 44. For example, in the third embodiment, as illustrated in FIG. 13, the weakened silts 43 can be replaced as a whole with the weakened grooves 44, or the weakened silts 43 are connected to the weakened grooves 44 in the radial direction of the gasket, which can also effectively reduce the structural strength of the limit member 40.

Further, in some embodiments, a plurality of weakened grooves 44 is provided and arranged at intervals.

Exemplarily, a plurality of weakened grooves 44 is constructed, and the plurality of weakened grooves 44 may extend in a radial direction. The plurality of weakened grooves 44 is arranged at intervals about an axis of the first mounting hole 11. The weakened grooves 44 may also be constructed as annular-shaped grooves and arranged about an axis of the first mounting hole 11 at equiangular intervals.

In this way, a force distribution of the limit member 40 in a circumferential direction can be more uniform, and consistency of the force distribution in each region is better, to improve a sealing effect of the limit member 40 when the explosion-proof housing 100 is in the use state, as well as the response sensitivity during the switching of the explosion-proof housing 100 to the pressure relief state, balancing and optimizing the sealing performance of the explosion-proof housing 100 and the use safety of the explosion-proof housing 100.

It is to be understood that in the first embodiment, the weakening grooves 44 are formed into annular-shaped groove and disposed about the axis of the gasket to separate the gasket inner ring 41 from at least part of the gasket outer ring 42. As a result, a disengagement pressure threshold of the gasket inner ring 41 from the gasket outer ring 42 can match a pressure relief threshold of the explosion-proof housing 100, ensuring that the explosion-proof housing 100 can be relieved promptly, and improving the use safety of the explosion-proof housing 100.

Further, in the first embodiment, the weakened connection portion includes weakened silts 43. The weakened silts 43 is disposed about an axis of the gasket and connected to the gasket inner ring 41 and the gasket outer ring 42. The weakened silt 43 has a thickness smaller than a thickness of the gasket inner ring 41 and a thickness of the gasket outer ring 42, to reduce the connection strength between the gasket outer ring 42 and the gasket inner ring 41.

As illustrated in FIGS. 7, 8, and 9, in the first embodiment, according to some embodiments of the present disclosure, the first end surface 111 has an inner diameter smaller than an inner diameter of the gasket outer ring 42 and greater than an outer diameter of the gasket inner ring 41. The second end surface 112 has an inner diameter smaller than an inner diameter of the gasket inner ring 41 and an outer diameter greater than or equal to an outer diameter of the gasket inner ring 41.

As such, it can be ensured that after the gasket outer ring 42 is disengaged, the fastener 30 and the gasket inner ring 41 can be pushed to abut with the second end surface 112 under the pressure. Furthermore, the outer diameter of the second end surface 112 is greater than or equal to the outer diameter of the gasket inner ring 41, and the inner diameter of the second end surface 112 is smaller than the inner diameter of the gasket inner ring 41, and therefore the gasket inner ring 41 can be attached to the second end surface 112, ensuring a reliable and stable connection between the first housing body 10 and the second housing body 20 by the fastener 30 in the pressure relief state, ensuring that the first housing body 10 cannot be disengaged from the second housing body 20 in the pressure relief state.

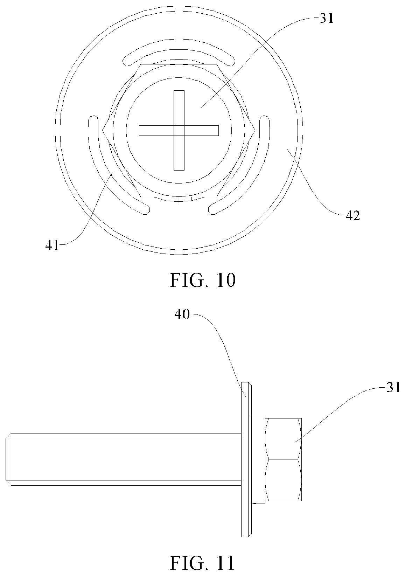

As illustrated in FIGS. 10 and 11, according to some embodiments of the present disclosure, the fastener 30 has an end extending into the first mounting hole 11 and the second mounting hole 21, and the limit head 31 has an outer diameter smaller than an inner diameter of the gasket outer ring 42 to remove the gasket outer ring 42 from the fastener 30 after the gasket outer ring 42 is separated from the gasket inner ring 41.

In this way, the gasket outer ring 42 can be removed from the limit head 31, avoiding the gasket outer ring 42 disengaged from the gasket inner ring 41 during the pressure relief from interfering with the pressure relief process, and improving the stability and the reliability of the explosion-proof housing 100 from the use state to the pressure relief state.

According to embodiments in a second aspect of the present disclosure, there is provided an electrical device including the explosion-proof housing 100 described in the above embodiments.

Exemplarily, the electrical device may be a generator, a transformer, a circuit breaker, and other devices, and has main functional components disposed in the accommodation space of the explosion-proof housing 100 to realize sealing relative to an ambient environment. In the event of a short circuit or an open circuit and when the pressure inside the explosion-proof housing 100 increases, the rapid pressure relief can be realized through the structure of the above-described limit member 40 to improve safety and reliability of the electrical device.

In the description of the present disclosure, it should be understood that, the orientation or the position indicated by terms such as "center", "longitudinal", "lateral", "length", "width", "thickness", "over", "below", "front", "rear", "left", "right", "vertical", "horizontal", "top", "bottom", "inner", "outer", "clockwise", "anti-clockwise", "axial", "radial", and "circumferential" should be construed to refer to the orientation and the position as shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure.

In the description of the present disclosure, "the first feature" and "the second feature" may include one or more of these features.

In the description of the present disclosure, "plurality" means two or more.

In the description of the present disclosure, the first feature "on" or "under" the second feature may mean that the first feature is in direct contact with the second feature, or the first and second features are in indirect contact through another feature between the first and second features.

In the description of the present disclosure, the first feature "above" the second feature means that the first feature is directly above or obliquely above the second feature, or simply means that the level of the first feature is higher than that of the second feature.

Throughout this specification, description with reference to "an embodiment", "some embodiments", "an illustrative embodiment", "an example", "a specific example", "some examples", or the like means that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Further, the particular features, structures, materials, or characteristics described here may be combined in any suitable manner in one or more embodiments or examples.

Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. An explosion-proof housing, comprising:
a first housing body (10) having a first mounting hole (11);
a second housing body (20) covering the first housing body (10) and having a second mounting hole (21);
a fastener (30) passing through the first mounting hole (11) and the second mounting hole (21) to connect the first housing body (10) to the second housing body (20); and
a limit member (40) disposed between the first mounting hole (11) and the fastener (30) and having a first state and a second state, wherein:
in the first state, the limit member (40) is adapted to limit a limit head (31) of the fastener (30) outside the first mounting hole (11); and
in the second state, at least part of the limit member (40) is disengaged from the limit head (31) to allow the limit head (31) to enter into the first mounting hole (11).

2. The explosion-proof housing according to claim 1, wherein the first mounting hole (11) has a first end surface (111) and a second end surface (112) that are arranged in sequence in an assembly direction, wherein:
in the first state, the limit head (31) is located outside the first end surface (111); and
in the second state, the limit head (31) is located outside the second end surface (112).

3. The explosion-proof housing according to claim 2, wherein the limit member (40) is constructed as a gasket disposed between the first mounting hole (11) and the limit head (31), the gasket comprising a gasket inner ring (41) and a gasket outer ring (42), a weakened connection portion being disposed between the gasket inner ring (41) and the gasket outer ring (42), and the weakened connection portion being adapted to be broken under a pressure, disengaging the at least part of the limit member (40) from the limit head (31) in the second state.

4. The explosion-proof housing according to claim 2, wherein the limit member (40) is constructed as a gasket disposed between the first mounting hole (11) and the limit head (31) and having a weakened connection portion, the weakened connection portion being adapted to be broken under a pressure, disengaging the limit member (40) from the limit head (31) in the second state.

5. The explosion-proof housing according to claim 2, wherein:
the limit member (40) is disposed at an end portion of the first mounting hole (11) and connected to the first housing body (10); and
a weakened connection portion is disposed between the first housing body (10) and the limit member (40), the weakened connection portion being adapted to be broken under a pressure, disengaging the limit member (40) from the limit head (31) in the second state.

6. The explosion-proof housing according to claim 2, wherein:
the limit member (40) is disposed at the limit head (31); and
a weakened connection portion is disposed between the limit head (31) and the limit member (40), the weakened connection portion being adapted to be broken under a pressure, disengaging the limit member (40) from the limit head (31) in the second state.

7. The explosion-proof housing according to any one of claims 3 to 6, wherein the weakened connection portion comprises weakened slits (43), the weakened slits (43) each having a thickness smaller than a thickness of the limit member (40) to disengage the at least part of the limit member (40) from the limit head (31).

8. The explosion-proof housing according to claim 7, wherein the weakened connection portion further comprises a weakened groove (44), the weakened groove (44) being constructed as a through groove to disengage the at least part of the limit member (40) from the limit head (31).

9. The explosion-proof housing according to claim 8, wherein the weakened groove (44) is disposed between the at least two weakened slits (43).

10. The explosion-proof housing according to claim 7, wherein the weakened slits (43) are disposed about an axis of the first mounting hole (11).

11. The explosion-proof housing according to claim 8, wherein a plurality of weakened grooves (44) is provided and arranged at equal intervals;
optionally, the plurality of weakened grooves (44) is constructed as annular-shaped grooves and arranged about an axis of the first mounting hole (11) at equiangular intervals.

12. The explosion-proof housing according to claim 3, wherein the first end surface (111) has an inner diameter smaller than an inner diameter of the gasket outer ring (42) and greater than an outer diameter of the gasket inner ring (41).

13. The explosion-proof housing according to claim 3, wherein the second end surface (112) has an inner diameter smaller than an inner diameter of the gasket inner ring (41) and an outer diameter greater than or equal to an outer diameter of the gasket inner ring (41).

14. The explosion-proof housing according to claim 3, wherein:
the fastener (30) has an end extending into the first mounting hole (11) and the second mounting hole (21); and
the limit head (31) has an outer diameter smaller than an inner diameter of the gasket outer ring (42) to remove the gasket outer ring (42) from the fastener (30) after the gasket outer ring (42) is separated from the gasket inner ring (41).

15. An electrical device, comprising the explosion-proof housing according to any one of claims 1 to 14.
